# EUROPEAN PATENT APPLICATION

(11) **EP 4 282 649 A1**
(43) Date of publication of application: **29.11.2023**
(21) Application number: 22742597.2
(22) Date of filing: 19.01.2022
(51) Int. Cl.: B32B 18/00, B32B 15/04, B32B 15/08, H05K 1/03

(54) **SUBSTRATE AND PRODUCT**

(30) Priority: 19.01.2021 JP 2021006530
(71) Applicant: Sasaki, Beji, Tokyo 101-0042 (JP)
(72) Inventor: Sasaki, Beji, Tokyo 101-0042 (JP)
(74) Representative: Hindles Limited
(86) International application number: PCT/JP2022/001731
(87) International publication number: WO 2022/158475

(57) **Abstract**

A substrate 1 has a composite substrate 10 having a resin part 30 and a plurality of ceramic parts 20 provided in the resin part 30, and a metal layer 50 provided on one side of the composite substrate 10. A surface on the other side of the metal layer 50 is in contact with the ceramic parts 20.

## Description

### Technical Field

The present invention relates to a substrate having a metal layer and a product.

### Background Art

Hitherto, there has been provided a laminate including a ceramic substrate and a metal layer made of a copper foil or the like and provided on the ceramic substrate via an adhesive. For example, JP 2017-035805 A provides a metal-ceramic bonded substrate in which a conductor layer made of copper or a copper alloy is stacked on at least one surface side of a silicon nitride substrate. As the metal-ceramic bonded substrate, there is provided a metal-ceramic bonded substrate in which an adhesive layer is interposed between a silicon nitride substrate and a conductor layer, and the silicon nitride substrate and the conductor layer are bonded to each other while having the adhesive layer interposed therebetween.

### SUMMARY OF INVENTION

### PROBLEM TO BE SOLVED BY INVENTION

However, in a case where an adhesive layer such as an adhesive is provided between the ceramic substrate and the metal layer, a thermal conductivity implemented by the ceramic substrate is greatly impaired. In addition, since a difference in linear expansion between the ceramic substrate and the metal layer is large, cracks may occur.

The present invention provides a substrate and the like that can implement a high thermal conductivity and reduce a possibility of occurrence of cracks.

### MEANS FOR SOLVING PROBLEM

A substrate according to an aspect of the present invention may comprise:
a composite substrate having a resin part and a plurality of ceramic parts provided in the resin part, and
a metal layer provided on one side of the composite substrate,
wherein a surface on the other side of the metal layer may be in contact with the ceramic parts.

According to the present invention, a substrate and the like that can implement a high thermal conductivity and reduce a possibility of occurrence of cracks can be provided.

### Brief Description of Drawings

Fig. 1 is a side cross-sectional view of a substrate according to an embodiment of the present invention.
Fig. 2 is a plan view of a composite substrate in an example of an embodiment of the present invention.
Fig. 3 is a plan view of a composite substrate in another example of an embodiment of the present invention.
Fig. 4 is a plan view of a composite substrate in still another example of an embodiment of the present invention.
Fig. 5 is a side cross-sectional view of a substrate according to a modified example of an embodiment of the present invention.
Fig. 6 is a side cross-sectional view of the substrate having an adhesive layer and a heat dissipation part.
Fig. 7 is a side cross-sectional view of the substrate having the heat dissipation part according to an embodiment of the present invention.
Fig. 8 is a side cross-sectional view illustrating an aspect in which a filler is included in a resin part according to an embodiment of the present invention.
Fig. 9 is a side cross-sectional view illustrating an aspect in which a fastening part is provided according to an embodiment of the present invention.
Fig. 10 is a side cross-sectional view illustrating an aspect in which a ceramic part is not exposed from the resin part on a back surface according to an embodiment of the present invention.
Fig. 11 is a side cross-sectional view illustrating an aspect in which a metal layer is provided on each of one surface and the other surface of the composite substrate according to an embodiment of the present invention.
Fig. 12 is a side cross-sectional view illustrating an aspect in which the adhesive layer is provided in the aspect of Fig. 11.
Fig. 13 is a side cross-sectional view illustrating an aspect in which the ceramic part is provided on both side surfaces of the metal layer according to an embodiment of the present invention.
Fig. 14 is a side cross-sectional view illustrating an aspect in which a cooling body is provided on a back surface of the composite substrate according to an embodiment of the present invention.
Fig. 15 is a side cross-sectional view illustrating an aspect in which the ceramic part and the resin part are provided on both side surfaces of the metal layer according to an embodiment of the present invention.

### DETAILED DESCRIPTION

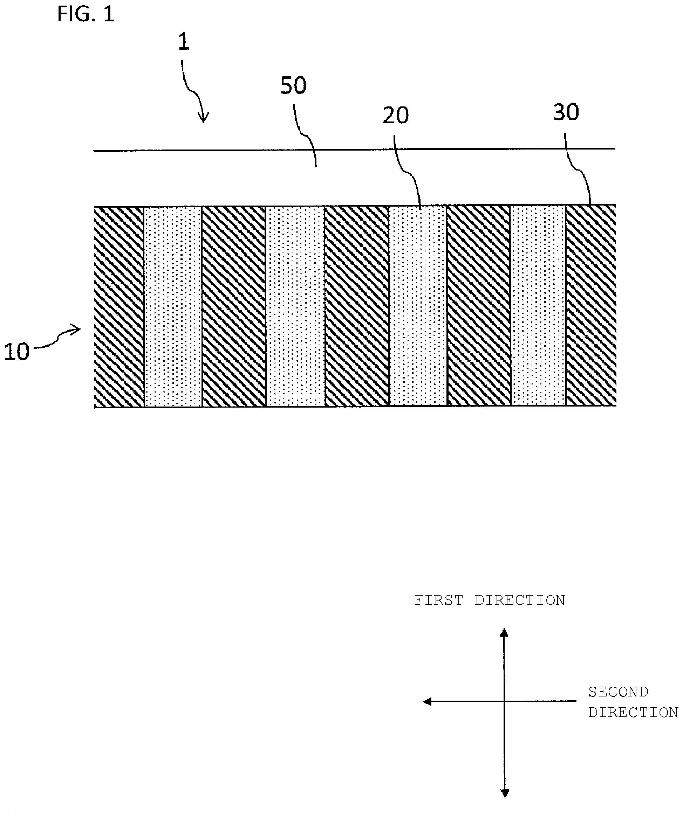

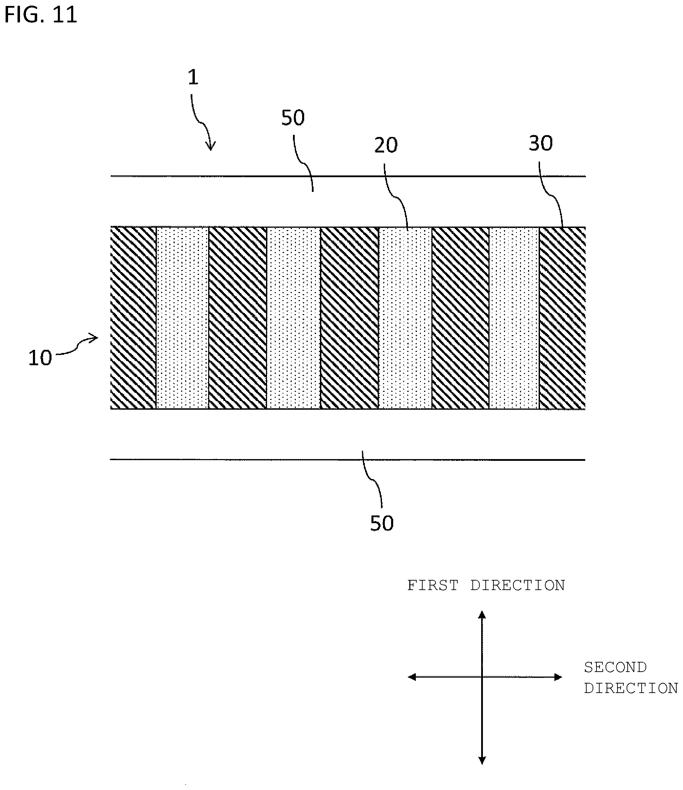

A substrate 1 of the present embodiment is a laminate, in which a plurality of layers are stacked. As illustrated in Fig. 1, the substrate 1 of the present embodiment may have a composite substrate 10 having a resin part 30 and a plurality of ceramic parts 20 scattered in the resin part 30, and a metal layer 50 provided on one surface (front surface) of the composite substrate 10. The metal layer 50 may be provided on the other surface (back surface) of the metal layer 50, or as illustrated in Fig. 11, the composite substrate 10 may be provided on both of the one surface and the other surface of the metal layer 50.

In Fig. 1, an upper side is one side, and a lower side is the other side. A vertical direction in Fig. 1 is a first direction, a horizontal direction is a second direction, and a front and back direction of a paper surface is a third direction. In the present embodiment, a plane including the second direction and the third direction is referred to as an in-plane.

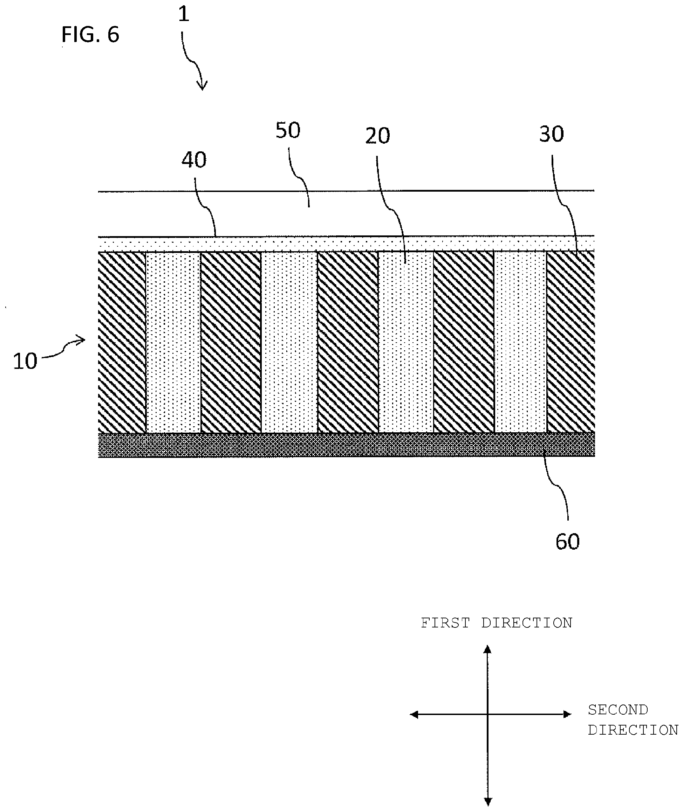

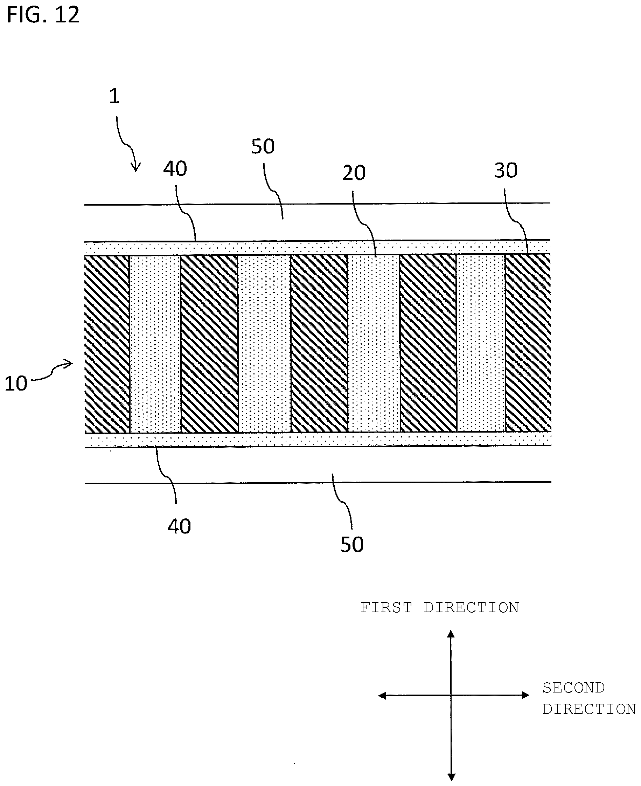

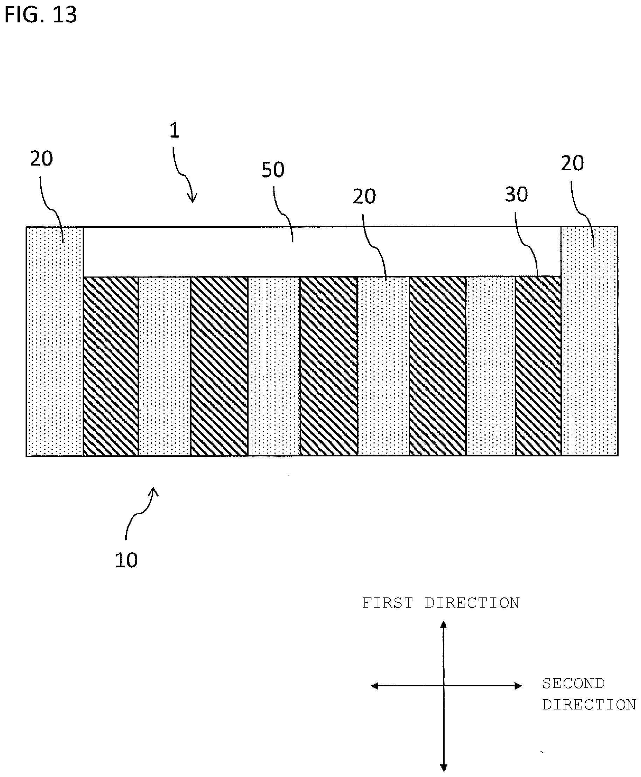

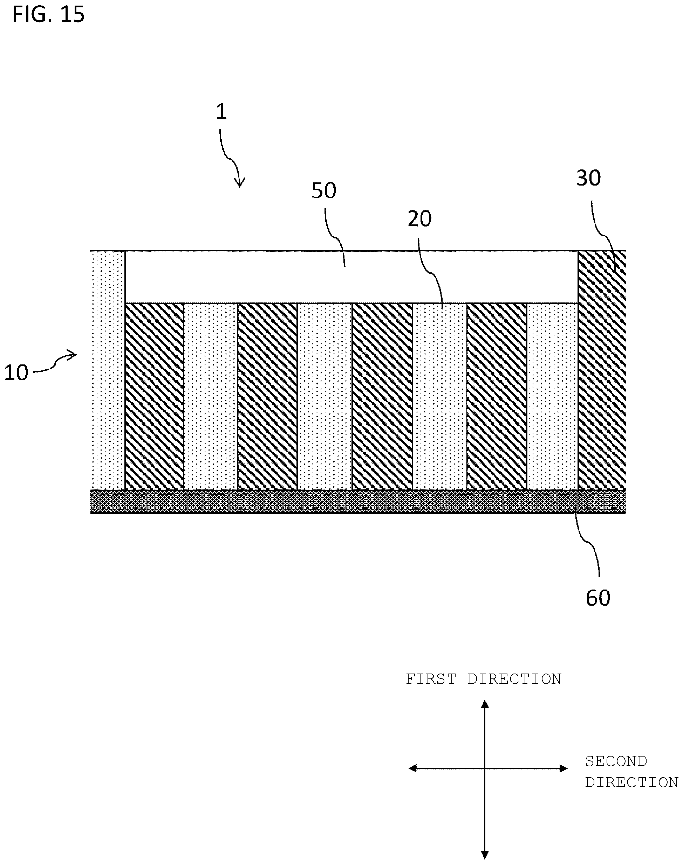

The other surface (back surface) of the metal layer 50 may be in contact with one surface of the ceramic part 20, and an adhesive layer or the like does not have to be provided between the other surface of the metal layer 50 and the one surface of the ceramic part 20. In this case, generally, the resin part 30 having an adhesion function is adhered to the other surface of the metal layer 50, so that the ceramic part 20 is fixed to the metal layer 50. However, the present invention is not limited to such an aspect, and as illustrated in Fig. 6, an adhesive layer 40 having a low thermal conductivity (for example, 1 W/m K or more) may be provided between the other surface of the metal layer 50 and the one surface of the ceramic part 20. Further, as illustrated in Fig. 12, the adhesive layer 40 having a low thermal conductivity (for example, 1 W/m K or more) may be provided on each of the one surface and the other surface of the metal layers 50, and the composite substrate 10 may be provided via the adhesive layer 40. As the resin part 30, an insulating resin part may be used. The ceramic part 20 or the metal layer 50 may be provided on one side surface or both side surfaces of the metal layer 50. For example, the ceramic part 20 may be provided on one side surface or both side surfaces of the metal layer 50 (see Fig. 13), or the resin part 30 may be provided on one side surface or both side surfaces of the metal layer 50. The term "contact" in the present embodiment may naturally include contact by plating. In addition, the composite substrate 10 may be provided on one side surface or both side surfaces of the metal layer 50, and in a case where the composite substrate 10 is provided on both side surfaces of the metal layer 50, a part of or the entire metal layer 50 may be embedded in the composite substrate 10 (see Fig. 15).

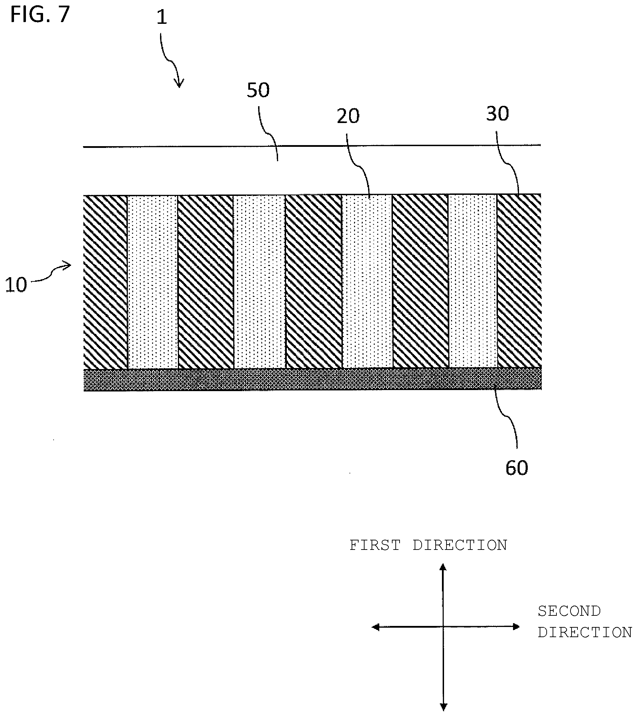

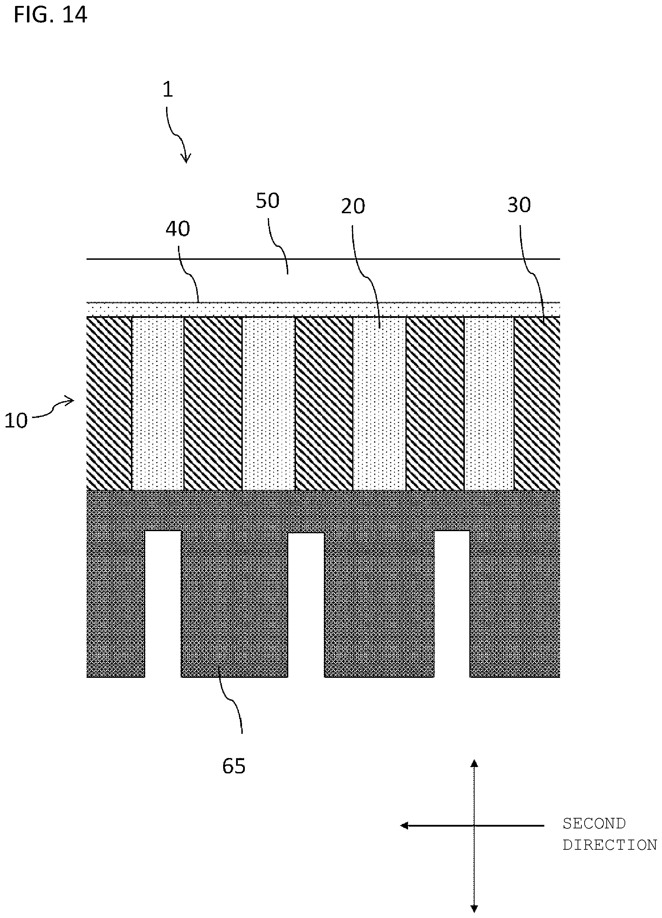

As illustrated in Figs. 6 and 7, a heat dissipation part 60 such as a heat dissipation plate made of copper or the like may be provided on the other surface (back surface) of the composite substrate 10. A cooling body 65 such as a heat sink may be provided on the other surface (back surface) of the substrate 1 (see Fig. 14).

The metal layer 50 may be made of, for example, copper, or may be made of a copper foil or a copper plate. A circuit may be formed on the metal layer 50 in a post-process, or the metal layer 50 on which a circuit is already formed may be provided to form a circuit layer.

In a case where an aspect in which the metal layer 50 and the ceramic part 20 are in contact with each other is used, heat transferred from an electronic component or the like placed on the metal layer 50 is efficiently transferred from the metal layer 50 to the ceramic part 20, and thus, the thermal conductivity is not impaired.

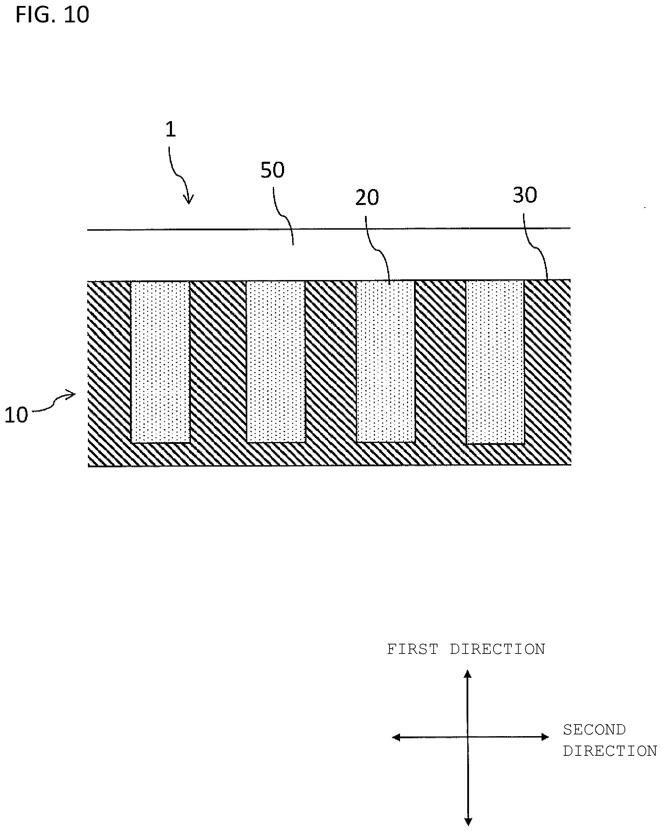

As illustrated in Fig. 1, the ceramic part 20 may be exposed from the resin part 30 on the other surface (back surface). In this case, since the heat transferred from the metal layer 50 to the ceramic part 20 is released from the other surface, an excellent heat dissipation effect can be achieved. However, as illustrated in Fig. 10, the ceramic part 20 does not have to be exposed from the resin part 30 on the other surface (back surface).

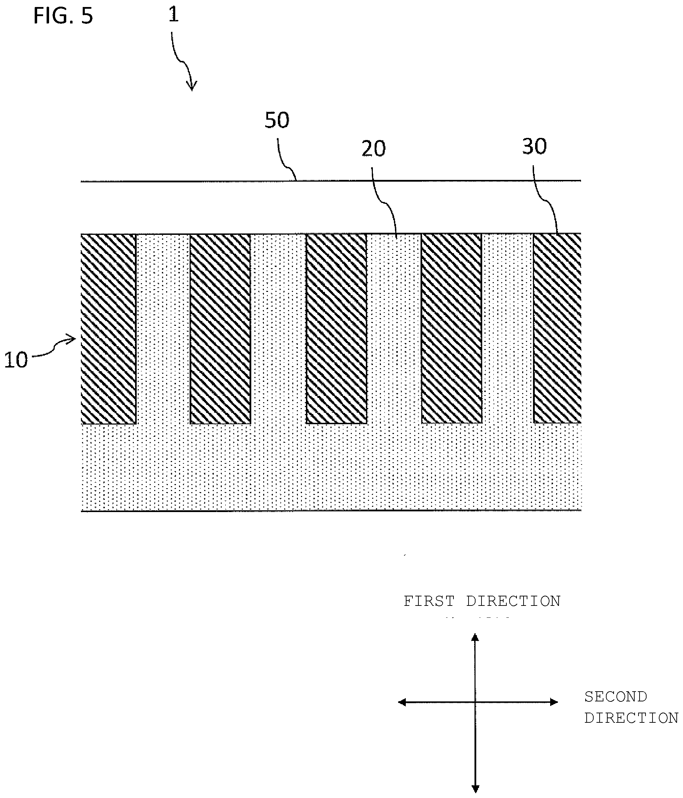

In addition, as illustrated in Fig. 5, the ceramic part 20 may be connected with each other on the other side and spread in the plane. In this case, the ceramic part 20 can be widely provided in the plane, and a greater heat dissipation effect can be achieved.

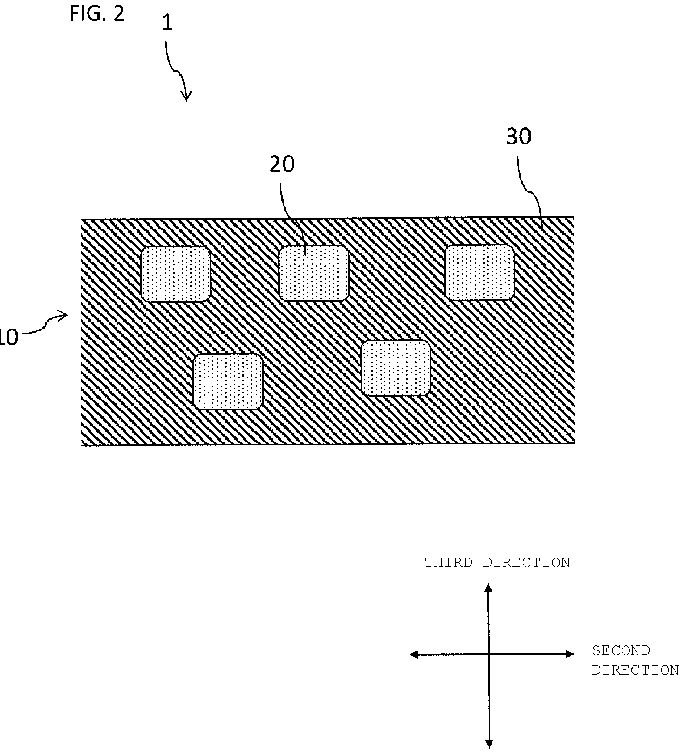

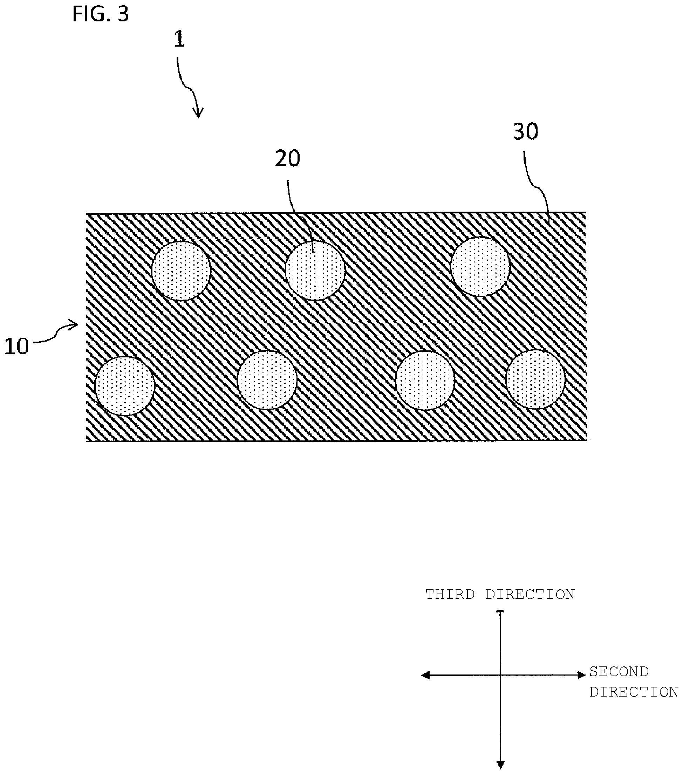

As illustrated in Figs. 2 and 3, the ceramic parts 20 may be provided like islands in the in-plane direction inside the resin part 30. In this case, thermal expansion can be made by the resin part 30 in the entire plane. In general, since a linear expansion coefficient between the metal layer 50 made of copper or the like and the resin part 30 has a close value, it is possible to prevent occurrence of cracks due to a difference in linear expansion coefficient as in the related art.

The ceramic part 20 may have a polygonal columnar shape or a cylindrical shape. In this case, the ceramic part 20 has a polygonal shape or a circular shape when viewed in the in-plane direction (see Figs. 2 and 3). The polygonal shape of the present embodiment also includes a substantial polygonal shape having rounded corners (see Fig. 2).

As a ceramic used in the ceramic part 20, for example, alumina, aluminum nitride, boron nitride, silicon nitride, silicon carbide, beryllia, or the like may be used. These ceramics may be used alone or in combination of two or more thereof. An approximate value (estimated value) of the thermal conductivity in the composite substrate 10 can be calculated by the thermal conductivity of the ceramic part 20 × a cross-sectional area (in-plane direction) of the ceramic part 20/the total area + the resin part 30 × a cross-sectional area (in-plane direction) of the resin part 30/the total area. For example, in a case where alumina is used as the ceramic part 20, the thermal conductivity is about 10 to 30 w/m·k, and in a case where aluminum nitride is used as the ceramic part 20, the thermal conductivity is about 80 to 150 w/m-k.

The resin part 30 may be a thermoplastic resin, or the resin part 30 may be a thermosetting resin. As a resin material, for example, an epoxy resin may be used. The resin material is not limited thereto, and an unsaturated polyester resin, a vinyl ester resin, a bismaleimide resin, a benzoxazine resin, a triazine resin, a phenol resin, a urea resin, a melamine resin, a polyimide resin, a polyolefin-based resin, an aliphatic polyamide-based resin, a semi-aromatic polyamide-based resin, an aromatic polyester-based resin, a polycarbonate-based resin, a polystyrene-based resin, or the like may be used.

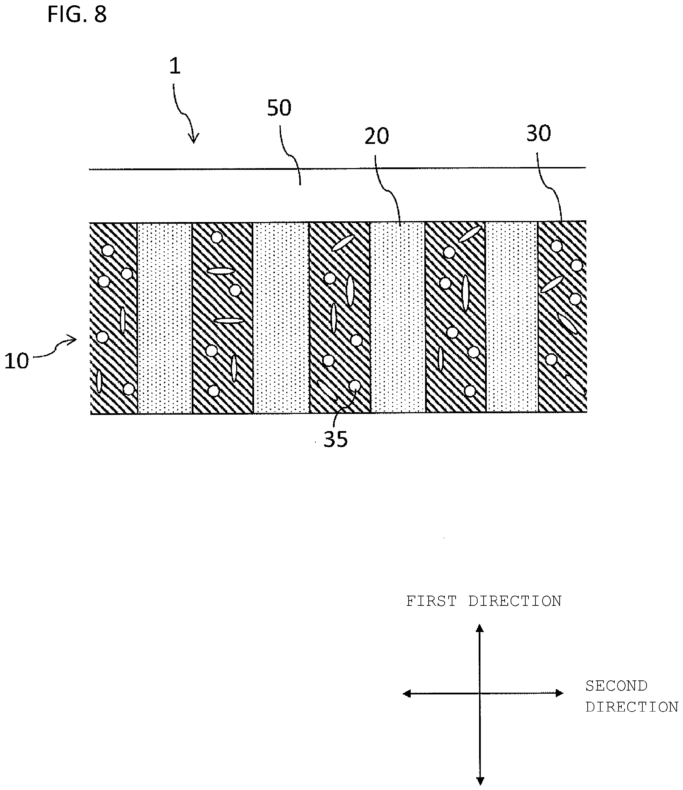

As illustrated in Fig. 8, a filler 35 sealed by the resin part 30 may be provided. The filler 35 may have a particle shape or a fiber shape. As the filler 35, a conductive filler can be used, and a metal material or a carbon material may be used. As the metal material, metal particles, metal fibers, organometallic particles, organometallic complex particles, metal nanoparticles, metal nanofibers, organometallic nanoparticles, or the like may be used. As the carbon material, for example, graphite particles, carbon particles, carbon milled fibers, carbon black, carbon nanotubes, vapor grown carbon fibers (VGCF), and the like may be used.

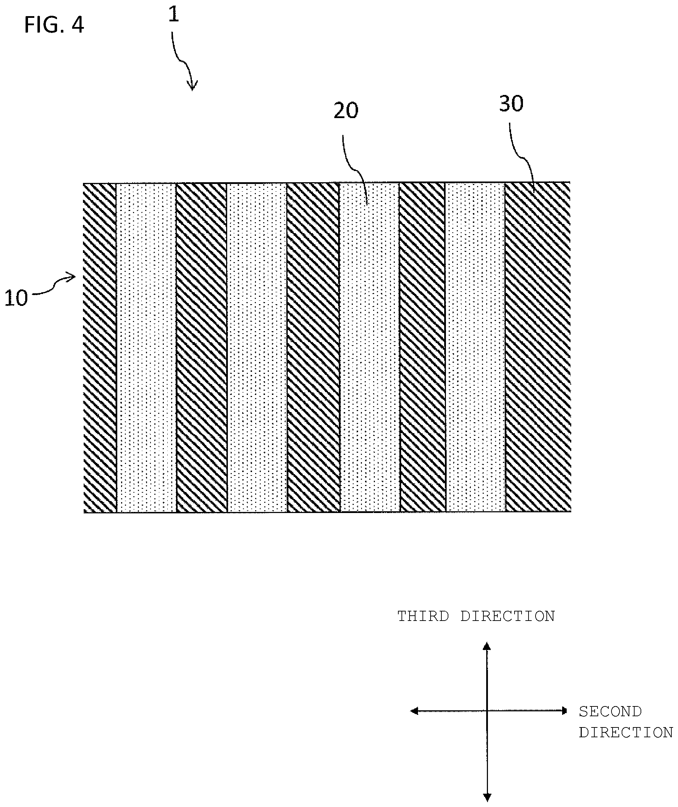

Fig. 4 is a plan view including the second direction and the third direction, and the ceramic part 20 may be arranged in a stripe pattern in plan view. In Fig. 4, the ceramic part 20 may have a plate shape, and the ceramic parts 20 having a plate shape may be adhered to each other by the resin part 30. In this case, the ceramic part 20 having a plate shape is positioned between the resin parts 30. A plurality of composite substrates 10 may be stacked to form a multilayer plate. In this case, a plurality of combinations of the composite substrates 10 and the metal layers 50 may be stacked in a thickness direction to form the multilayer plate.

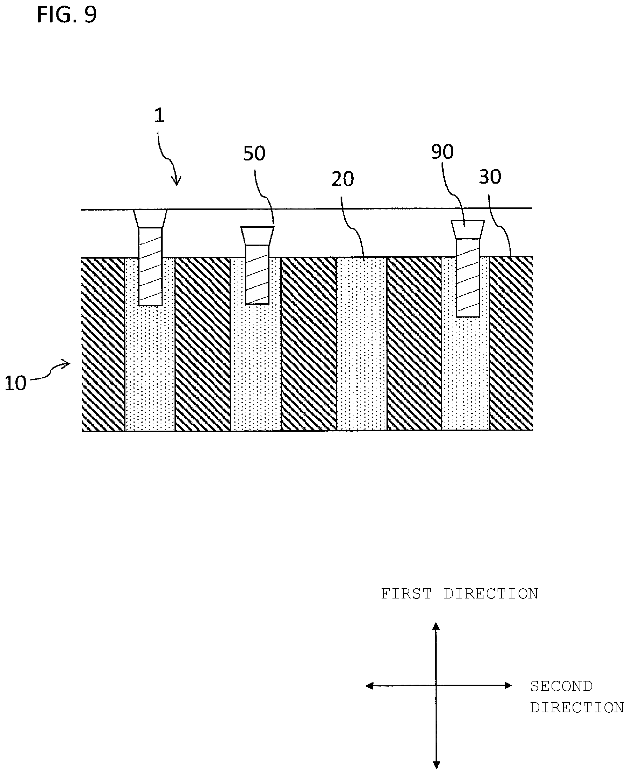

As illustrated in Fig. 9, a fastening part 90 such as a screw for fastening the resin part 30 and the metal layer 50 may be provided. Each of the resin part 30 and the metal layer 50 may be fastened by the fastening part 90, or some of a plurality of resin parts 30 and the metal layer 50 may be fastened by the fastening part 90. By using such an aspect, the resin part 30 and the metal layer 50 can be more reliably fixed.

An adhesive having a high thermal conductivity may be provided between the metal foil and the ceramic, the resin, or both. A metal layer made of a metal foil or the like may be directly placed on the composite substrate 10 made of a resin and a ceramic in an electroless plating bath or with an adhesive layer interposed therebetween. Alternatively, a primary layer may be a metal layer made of an electroless plating metal foil or the like, a secondary layer may be a metal layer made of an electroplating metal foil or the like, and the primary and secondary layers may be reversed upside down.

The substrate 1 in the above-described embodiment may be provided with an electronic component such as a semiconductor element, a capacitor, or a resistor. The electronic component may be sealed by a sealing part to provide an electronic apparatus (including a package) such as an IC package or an electronic device. Such an electronic apparatus may be incorporated into any mounting apparatus such as an automobile, an airplane, a ship, a helicopter, a personal computer, or a home appliance. In addition, an insulating printed circuit board, a house, or the like using the substrate 1 as in the present embodiment may be provided. The product of the present embodiment may include any object such as an electronic component, a device, an electrical product, a communication device, or a vehicle.

The description of each embodiment and variation, and the disclosure of the figures described above are merely examples for describing the invention described in the claims, and the invention described in the claims is not limited by the description of the embodiments or the disclosure of the figures described above.

### REFERENCE SIGNS LIST

- 1: Substrate
- 10: Composite substrate
- 20: Ceramic part
- 30: Resin part
- 50: Metal layer
- 90: Fastening part

## Claims

1. A substrate comprising:
a composite substrate having a resin part and a plurality of ceramic parts provided in the resin part, and
a metal layer provided on one side of the composite substrate,
wherein a surface on the other side of the metal layer is in contact with the ceramic parts.

2. The substrate according to claim 1,
wherein the ceramic parts are exposed from the resin part on a surface of the other side.

3. The substrate according to claim 2,
Wherein the ceramic parts are connected with each other on the other side.

4. The substrate according to any one of claims 1 to 3,
wherein the ceramic parts are provided like islands in an in-plane direction inside the resin part.

5. The substrate according to any one of claims 1 to 4,
wherein the ceramic parts have a polygonal columnar shape or a cylindrical shape.

6. The substrate according to any one of claims 1 to 5,
wherein fastening parts for fastening the resin part and the metal layer are provided.

7. The substrate according to any one of claims 1 to 6,
wherein the resin part or the ceramic part is provided on a lateral side of the metal layer.

8. A substrate comprising:
a composite substrate having a resin part and a plurality of ceramic parts provided in the resin part, and
a metal layer provided on one side of the composite substrate, and
an adhesive layer between the metal layer and the composite substrate.

9. A product including the substrate according to any one of claims 1 to 8.
